# EUROPÄISCHE PATENTSCHRIFT

(11) **EP 1 746 426 B1**
(45) Veröffentlichungstag und Bekanntmachung des Hinweises auf die Patenterteilung: **06.03.2019**
(21) Anmeldenummer: 06116536.1
(22) Anmeldetag: 04.07.2006
(51) Int. Cl.: G01R 15/20

(54) **Stromsensor**
Current sensor
Capteur de courant

(30) Priorität: 22.07.2005 CH 12242005
(43) Veröffentlichungstag der Anmeldung: 24.01.2007
(73) Patentinhaber: Melexis Technologies NV, 3980 Tessenderlo (BE)
(72) Erfinder: Racz, Robert, 6300, Zug (CH); Schott, Christian, 1167, Lussy-sur-Morges (CH)
(74) Vertreter: Falk, Urs

(56) Entgegenhaltungen:
- EP-A- 0 292 636
- EP-A- 1 182 461
- EP-A1- 0 204 135
- EP-A1- 0 244 577
- EP-A1- 0 338 122
- EP-A1- 1 443 332
- EP-A2- 0 772 046
- DE-A1- 10 038 645
- DE-A1- 19 842 241
- JP-A- 62 098 267
- US-A1- 2004 207 031

## Beschreibung

Die Erfindung betrifft einen Stromsensor der im Oberbegriff des Anspruchs 1 genannten Art.

Ein aus der EP 772046 bekannter Stromsensor besteht aus einem Halbleiterchip mit zwei auf der Oberfläche des Halbleiterchips angeordneten Magnetfeldkonzentratoren, die durch einen Luftspalt getrennt sind, und zwei im Halbleiterchip integrierten horizontalen Hallelementen, die beidseits des Luftspalts angeordnet sind, so dass sie von Feldlinien des Magnetfelds durchflutet werden, die vom ersten Magnetfeldkonzentrator in der Nähe des Luftspalts weggehen und auf den zweiten Magnetfeldkonzentrator in der Nähe des Luftspalts auftreffen. Dieser Stromsensor meist mehrere Vorteile auf. So können insbesondere die Magnetfeldkonzentratoren auf den Wafer mit den Halbleiterchips aufgebracht werden und der Wafer erst nachher in die individuellen Halbleiterchips zersägt werden. Der Halbleiterchip enthält zudem die für den Betrieb der Hallelemente und die Verstärkung und Auswertung der von den Hallelementen gelieferten Spannungssignale nötigen elektronischen Schaltungen. Ein weiterer Vorteil ist, dass der Stromsensor direkt auf einem Stromleiter angeordnet werden kann, weil die vom Strom erzeugten Magnetfeldlinien annähernd parallel zur Oberfläche des Halbleiterchips und damit auch parallel zu den Magnetfeldkonzentratoren verlaufen. Die Technologie der horizontalen Hallelemente ist weit entwickelt, so dass die mit dieser Technologie hergestellten Stromsensoren in ihrem Arbeitsbereich sehr genaue Messresultate liefern, deren Fehler in einem Bereich von beispielsweise 0 bis 50A kleiner als 0.1% und im daran anschliessenden Bereich von 50 bis 100A kleiner als 1% ist. Der Arbeitsbereich eines solchen Stromsensors erstreckt sich also von 0 bis 100A.

Eine Weiterentwicklung eines solchen Stromsensors ist bekannt aus der EP 1443332, bei dem der Halbleiterchip auf ein Leadframe montiert und als IC verkapselt ist, wobei das Leadframe selbst als Stromleiter ausgebildet ist und somit zwei Anschlussbeinchen des IC's als Anschlüsse für die Zuführung und Wegführung des zu messenden Stromes dienen.

Bei einigen Anwendungen kommt es nun vor, dass der Strom kurzzeitig auf weit über 100A ansteigt, beispielsweise auf 1000A, 1500A oder sogar 2000A. Ursache eines solchen Stromstosses kann beispielsweise ein Kurzschluss sein. Für solche Anwendungen können diese Stromsensoren nicht verwendet werden, weil das Messsignal oberhalb eines vorgegebenen Grenzstroms konstant ist. Der Grund dafür ist, dass die Magnetfeldkonzentratoren bei Erreichen des Grenzstroms gesättigt sind, so dass der durch die horizontalen Hallelemente gelenkte Magnetfeldfluss bei zunehmendem Strom nicht weiter ansteigt.

Bekannt sind auch Stromsensoren mit einem ferromagnetischen Joch, das den Stromleiter umschliesst. Das Joch enthält einen Luftspalt, in den ein IC mit einem horizontalen Hallelement eingebaut ist. Diese Geometrie ist als C-Shape bekannt. Auch diese Stromsensoren können bei Anwendungen, bei denen der Strom weit über den nominalen Messbereich hinaus ansteigen kann, nicht eingesetzt werden, weil das ferromagnetische Material bei zu grosser magnetischer Sättigung Hystereseeffekte zeigt, was nicht akzeptable Messfehler zur Folge haben würde.
Bei Anwendungen, bei denen der Stromsensor in einem vorgegebenen Messbereich ein Messsignal mit einer vorbestimmten Genauigkeit abgeben muss und in einem vorgegebenen Überlastbereich ein Messsignal geringerer Genauigkeit abgeben muss, ist als einzige Lösung die Kombination von zwei separaten Stromsensoren beispielsweise aus der JP 6298267 oder der DE 10038645 bekannt. Der erste Stromsensor deckt den Messbereich ab, der zweite Stromsensor oder allenfalls sogar ein dritter Stromsensor decken den Überlastbereich ab. Diese Lösung ist aber teuer. Zudem müssen die Empfindlichkeiten der einzelnen Sensoren aneinander angepasst werden, um eine kontinuierliche Ausgangskennlinie zu erhalten.

Aus der EP 292636 und der EP 0537419 ist ein Stromsensor bekannt, bei dem ein vertikales Hallelement im Luftspalt Zwischen zwei ferromagnetischen Blechstreifen angeordnet ist. Die ferromagnetischen Blechstreifen in der EP 292636 bilden zusammen mit einem geschlossenen Ring aus ferromagnetischem Material einen ferromagnetischen Kern, der das von dem durch den Stromleiter fliessenden Strom erzeugte Magnetfeld verstärkt. Für die Abschirmung äusserer Störfelder ist eine zusätzliche geschlossene Abschirmung aus ferromagnetischem Material vorgesehen, die den ferromagnetischen Kern vollständig umschliesst.
Der Erfindung liegt die Aufgabe zugrunde, einen kostengünstigen Stromsensor zu entwickeln, der in einem ersten vorgegebenen Messbereich ein Messsignal mit grosser Empfindlichkeit und Auflösung liefert und in einem zweiten vorgegebenen Messbereich ein Messsignal mit vergleichsweise kleinerer Empfindlichkeit und Auflösung liefert.
Die genannte Aufgabe wird erfindungsgemäss gelöst durch die Merkmale des Anspruchs 1.
Die Begriffe "horizontales Hallelement" und "vertikales Hallelement" werden wie in der einschlägigen Literatur üblich verwendet: Vertikale Hallelemente weisen mindestens drei, in der Regel aber vier oder fünf elektrische Kontakte auf, die entlang einer Geraden angeordnet sind. Solche vertikale Hallelemente sind beispielsweise aus der EP 148330 oder der EP 362493 bekannt. Horizontale Hallelemente sind empfindlich auf die Komponente des Magnetfeldes, die senkrecht auf ihre Oberfläche auftrifft, während vertikale Hallelemente empfindlich sind auf die Komponente des Magnetfeldes, die parallel zu ihrer Oberfläche und senkrecht zur Geraden mit den Kontakten verläuft.

Ein beispielhafter Stromsensor besteht aus einem Halbleiterchip mit mindestens einem auf einer Oberseite des Halbleiterchips angeordneten Magnetfeldkonzentrator, mindestens einem Hallelement, das im Bereich des Randes des mindestens einen Magnetfeldkonzentrators angeordnet ist und einer elektronischen Schaltung für den Betrieb des mindestens einen Hallelementes und die Auswertung des vom mindestens einen Hallelement gelieferten Spannungssignals. Der Stromsensor wird auf einem Stromleiter platziert. Der mindestens eine Magnetfeldkonzentrator lenkt das Magnetfeld lokal um 90° um. Der Stromleiter erzeugt beispielsweise ein Magnetfeld, das im Bereich des Halbleiterchips annähernd in die x-Richtung zeigt. Der mindestens eine Magnetfeldkonzentrator lenkt dieses Magnetfeld lokal um 90° um, so dass es an gewissen Stellen seines Randes in die z-Richtung zeigt, wobei x und y die Achsen eines kartesischen Koordinatensystems bezeichnen. Das mindestens eine Hallelement ist entweder ein horizontales Hallelement, das unterhalb des Randes des Magnetfeldkonzentrators angeordnet ist, oder ein vertikales Hallelement, das seitlich versetzt neben dem Rand des Magnetfeldkonzentrators angeordnet ist, wo die umgelenkten Feldlinien bereits wieder in x-Richtung verlaufen. Falls das mindestens eine Hallelement ein horizontales Hallelement ist, dann ist zusätzlich ein vertikales Hallelement im Halbleiterchip integriert. Das vertikale Hallelement liefert immer eine monoton mit dem extern anliegenden Magnetfeld ansteigende Hallspannung, unabhängig davon, ob der mindestens eine Magnetfeldkonzentrator magnetisch gesättigt ist oder nicht. Die elektronische Schaltung ist ausgelegt zum Betrieb aller Hallelemente, sofern mehr als eines vorhanden ist, und zur Bildung eines Messsignals aus den von den Hallelementen gelieferten Hallspannungen. Der Halbleiterchip kann entweder allein als IC verpackt werden oder der Halbleiterchip kann zusammen mit dem Stromleiter als IC verpackt werden, wobei der IC den Stromsensor darstellt.
Die Erfindung wird nachfolgend anhand von Ausführungsbeispielen und anhand der Zeichnung näher erläutert.
Es zeigen:
- Fig. 1: einen Stromsensor gemäss einem ersten Ausführungsbeispiel der Erfindung,
- Fig. 2: eine Kennlinie des Stromsensors,
- Fig. 3: einen Stromsensor gemäss der Erfindung,
- Fig. 4: horizontale und vertikale Hallelemente,
- Fig. 5: den auf einem Stromleiter montierten Stromsensor,
- Fig. 6, 7: weitere Stromsensoren mit einer Abschirmung aus ferromagnetischem Material, und
- Fig. 8 bis 11: Blockschemata verschiedener Möglichkeiten für die Verarbeitung der Hallspannungen der verschiedenen Hallelemente, sofern mehr als ein Hallelement vorhanden ist.

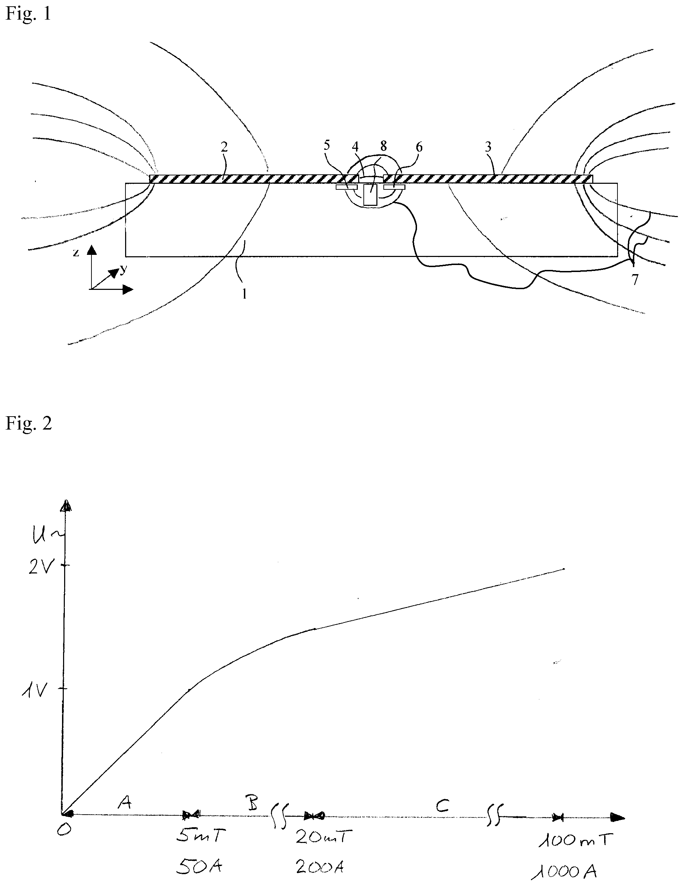

Die Fig. 1 zeigt im Querschnitt einen Stromsensor gemäss einem ersten Ausführungsbeispiel der Erfindung. Die Achsen eines kartesischen Koordinatensystems sind mit x, y und z bezeichnet. Die y-Richtung verläuft senkrecht zur Zeichenebene. Der Stromsensor wird in später dargestellter Weise auf einem Stromleiter montiert. Der durch den Stromleiter fliessende Strom erzeugt ein Magnetfeld, das im Bereich des Stromsensors in x-Richtung gerichtet ist. Der Stromsensor umfasst einen Halbleiterchip 1 mit zwei auf der Oberfläche des Halbleiterchips 1 angeordneten Magnetfeldkonzentratoren 2 und 3, die durch einen Luftspalt 4 getrennt sind, und zwei im Halbleiterchip 1 integrierten horizontalen Hallelementen 5 und 6, die beidseits des Luftspalts 4 unterhalb des darüberliegenden Magnetfeldkonzentrators 2 bzw. 3 angeordnet sind, so dass sie von Feldlinien 7 des Magnetfelds durchflutet werden, die vom ersten Magnetfeldkonzentrator 2 in der Nähe des Luftspalts 4 weggehen und auf den zweiten Magnetfeldkonzentrator 3 in der Nähe des Luftspalts 4 auftreffen. Die beiden Magnetfeldkonzentratoren 2 und 3 erstrecken sich in der xy-Ebene, der Luftspalt 4 verläuft in y-Richtung. Die beiden Magnetfeldkonzentratoren 2 und 3 verstärken die x-Komponente des von dem durch den Stromleiter fliessenden Strom erzeugten Magnetfelds und die beiden horizontalen Hallelemente 5 und 6 messen die verstärkte x-Komponente des Magnetfelds. Da die Feldlinien 7, die der x-Komponente des Magnetfelds entsprechen, die beiden horizontalen Hallelemente 5 und 6 in entgegengesetzter vertikaler Richtung durchdringen, addieren sich bei entsprechender Beschaltung die Spannungen, die durch die "Umlenkung" des Magnetfeldes entstehen, während sich Hallspannungen, die beispielsweise aufgrund eines externen, die horizontalen Hallelemente 5 und 6 senkrecht durchdringenden magnetischen Störfeldes entstehen, sich gegenseitig aufheben. Die z-Komponente des Magnetfelds wird auf diese Weise eliminiert. Der Halbleiterchip 1 enthält weiter ein vertikales Hallelement 8, das unterhalb des Luftspalts 4 zwischen den beiden horizontalen Hallelementen 5 und 6 angeordnet ist und dessen Kontakte sich in y-Richtung erstrecken, so dass seine Hallspannung maximal ist, wenn die Feldlinien des magnetischen Feldes in x-Richtung verlaufen. Der Halbleiterchip 1 enthält weiter die für den Betrieb der Hallelemente 5, 6 und 8 und die Verstärkung und Aufbereitung der an den Hallelementen 5, 6 und 8 anliegenden Hallspannungen erforderliche Elektronik. Die Elektronik umfasst in der Regel einen analogen und einen digitalen Schaltteil.

Die Fig. 2 zeigt die Kennlinie des Stromsensors unter der Voraussetzung, dass die Hallspannungen der drei Hallelemente 5, 6 und 8 zu einem einzigen Messsignal addiert werden. Die Kennlinie stellt das Messsignal U in Funktion eines in x-Richtung gerichteten Magnetfeldes bzw. in Funktion der Stromstärke des zu messenden Stromes dar. Die Kennlinie ist charakterisiert durch drei aneinander angrenzende Bereiche A, B und C. Im Bereich A, der im Beispiel von 0 bis 5mT bzw. von 0 bis 50A reicht, ist das Messsignal linear und der Fehler geringer als 0.1%. Die Kennlinie ist in diesem Bereich steil, d.h. es wird beim Wert von 5mT bereits ein Messsignal von 1V erreicht. Im Bereich A tritt noch keine magnetische Sättigung der Magnetfeldkonzentratoren 2 und 3 auf. Im Bereich B ist die Kennlinie gekrümmt, weil die Magnetfeldkonzentratoren 2 und 3 magnetisch zunehmend in Sättigung kommen. Bei Erreichen der oberen Bereichsgrenze, im Beispiel bei 20mT bzw. 200A, sind die Magnetfeldkonzentratoren 2 und 3 magnetisch vollständig gesättigt, d.h. die Stärke des durch die beiden Magnetfeldkonzentratoren 2 und 3 umgelenkten Magnetfelds nimmt mit weiter zunehmender Stärke des externen Magnetfelds nicht mehr zu. Das Messsignal erreicht beim Wert von 20mT etwa 1.5V. Im Bereich C, in dem nur noch die Hallspannung des vertikalen Hallelements 8 zunimmt, ist das Messsignal wieder annähernd linear, aber die Kennlinie ist viel weniger steil als im Bereich A, weil die Empfindlichkeit des vertikalen Hallelementes 8 geringer als die Empfindlichkeit der horizontalen Hallelemente 5 und 6 ist und weil das Magnetfeld nicht mehr verstärkt wird. Der Bereich C erstreckt sich im Beispiel von 20mT bis 100mT entsprechend einer Stromstärke von 200A bis typischerweise 1000A. Der Arbeitsbereich des Stromsensors umfasst je nach Anwendung nur den Bereich A oder beide Bereiche A und B.
Der Bereich A entspricht dem ersten vorgegebenen Messbereich und stellt den Arbeitsbereich dar, in welchem der Stromsensor ein Messsignal mit hoher Auflösung liefert. Der Bereich C entspricht dem zweiten vorgegebenen Messbereich und stellt den Überlastbereich dar, in dem die Genauigkeit des Stromsensors geringer als im Arbeitsbereich, aber durchaus brauchbar ist. Der Bereich B ist ein Übergangsbereich, der je nach Anwendung entweder dem Arbeitsbereich oder dem Überlastbereich zugeordnet wird.
Ein wichtiger Vorteil dieses Stromsensors besteht darin, dass der Ausgangsspannungsbereich des Arbeitsbereichs von 0 bis 200A, wenn also der Bereich B dem Arbeitsbereich zugeordnet ist, etwa 1.5V beträgt, während der Ausgangsspannungsbereich des Überlastbereichs von 200A bis 1000A nur 0.5V beträgt. Dies ermöglicht eine den Anwendungen angepasste Auswertung.
Um technologiebedingte Offsetspannungen der Hallelemente so weit als möglich zu reduzieren, werden die Hallelemente bevorzugt mit der sogenannten "Spinning current" Methode betrieben, bei der die Strom- und Spannungskontakte laufend vertauscht werden. Zudem kann jedes Hallelement durch eine Gruppe von mindestens zwei Hallelementen ersetzt werden, die so verdrahtet sind, dass die durch die Hallelemente einer Gruppe fliessenden Ströme in unterschiedliche Richtungen fliessen. Insbesondere ist es vorteilhaft, das vertikale Hallelement 8 durch zwei vertikale Hallelemente zu ersetzen, die unmittelbar nebeneinander unterhalb des Luftspalts 4 angeordnet sind. In diesem Fall sind die beiden vertikalen Hallelemente bevorzugt sogenannte symmetrische vertikale Hallelemente, d.h. Hallelemente mit zwei inneren und zwei äusseren Kontakten, wobei die beiden inneren Kontakte gleich gross und die beiden äusseren Kontakte gleich gross sind.
Die horizontalen Hallelemente sind dort anzuordnen, wo die der x-Komponente des Magnetfelds entsprechenden Feldlinien den maximalen magnetischen Fluss erzeugen. Die horizontalen Hallelemente 5 und 6 sind deshalb wie in der Fig. 1 gezeigt, beidseits des Luftspalts 4 unterhalb des Randes der Magnetfeldkonzentratoren 2 und 3 platziert. Alternativ können die horizontalen Hallelemente auch unterhalb des äusseren Randes der Magnetfeldkonzentratoren 2 und 3 platziert werden. In diesem Fall können die beiden Magnetfeldkonzentratoren 2 und 3 durch einen einzigen Magnetfeldkonzentrator ersetzt werden. Es ist auch möglich, nur ein einziges horizontales Hallelement vorzusehen.

Bei nicht unter die Erfindung fallenden Beispielen kann das vertikale Hallelement 8 grundsätzlich überall platziert werden, sei es im Bereich des Randes eines Magnetfeldkonzentrators, wo die umgelenkten Feldlinien bereits wieder annähernd in x-Richtung verlaufen, oder irgendwo unterhalb des Magnetfeldkonzentrators oder sogar irgendwo abseits des Magnetfeldkonzentrators. Der Beitrag des vertikalen Hallelements 8 zum Messsignal ist dann je nach seiner Lage unterschiedlich für die Bereiche A und B, aber der gleiche für den Bereich C.

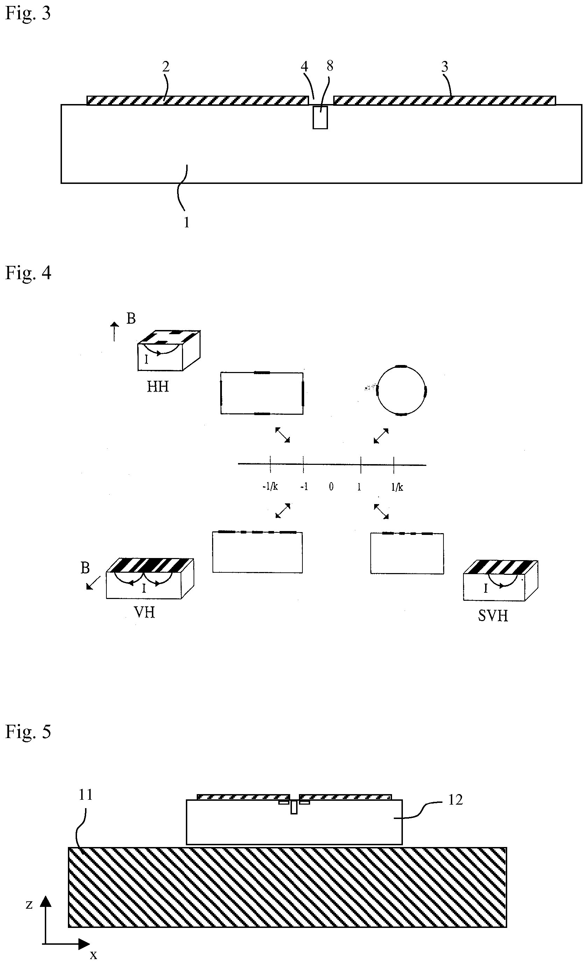

Die Fig. 3 zeigt ein Ausführungsbeispiel, bei dem nur das vertikale Hallelement 8 unterhalb des Luftspalts 4 vorhanden ist, bei dem also die horizontalen Hallelemente weggelassen wurden.
Die horizontalen Hallelemente sind, sofern mehr als eines vorhanden ist, bevorzugt fest miteinander verdrahtet. Ebenso sind die vertikalen Hallelemente, sofern mehr als eines vorhanden ist, bevorzugt fest miteinander verdrahtet. Nämlich so, dass die technologiebedingten Offsetspannungen so weit als möglich eliminiert werden. Zudem werden die parallel geschalteten horizontalen Hallelemente und die parallel geschalteten vertikalen Hallelemente bevorzugt im Zeitmultiplexbetrieb und mit der Spinning Current Methode betrieben, so dass ein einziger Verstärker für die Verstärkung der Hallspannungen genügt. Die Elektronik erzeugt bevorzugt ein einziges Messsignal.
Die Fig. 4 zeigt eine anschauliche Darstellung eines horizontalen Hallelementes HH, eines vertikalen Hallelementes VH mit fünf Kontakten und eines symmetrischen vertikalen Hallelementes SVH mit vier Kontakten, die Richtung des Magnetfeldes B, das von den Hallelementen gemessen wird, und die Richtung des im jeweiligen Hallelement fliessenden Stromes I. Die Figur zeigt weiter, wie die verschiedenen Hallelemente durch konforme Abbildungen ineinander transformiert werden können. Im Halbleiterchip 1 (Fig. 1) sind alle Hallelemente als n-Wanne in p-dotiertem Gebiet oder als p-Wanne in n-dotiertem Gebiet realisiert.
Die Fig. 5 zeigt im Querschnitt einen Stromleiter 11, auf dem ein erfindungsgemässer Stromsensor 12 montiert ist. Der Stromleiter 11 hat bevorzugt einen rechteckförmigen Querschnitt. Der Strom fliesst senkrecht zur Zeichenebene durch den Stromleiter 11. Dabei kann wie dargestellt die den Magnetfeldkonzentratoren 2, 3 abgewandte Seite des Stromsensors 12 dem Stromleiter 11 zugewandt sein. Es können aber auch die Magnetfeldkonzentratoren 2, 3 dem Stromleiter 11 zugewandt sein. Eine weitere Möglichkeit besteht darin, den Stromleiter 11 in den Stromsensor 12 zu integrieren. Ein solcher Stromsensor mit integriertem Stromleiter kann zudem mit einem magnetischen Joch versehen werden. Derartige Lösungen sind beispielsweise in der EP 772 046 oder der EP 1 443 332 beschrieben.

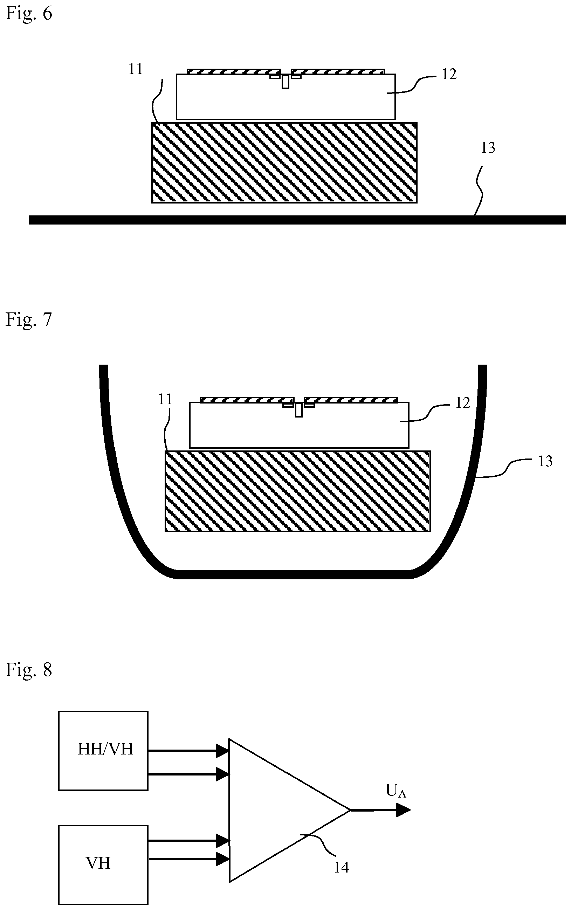

Die Fig. 6 und 7 zeigen im Querschnitt einen Stromsensor 12, der auf einem Stromleiter 11 montiert ist. Eine ebene bzw. u-förmlich gebogene Platte 13 aus ferromagnetischen Material mit hoher Permeabilität wie zum Beispiel Mumetall, die sich entlang des Stromleiters 11, d.h. senkrecht zur Zeichenebene, erstreckt, dient einerseits zur Erhöhung der Empfindlichkeit des Stromsensors durch Bündelung des Magnetfelds um den Stromleiter 11 und andererseits zur Abschirmung externer magnetischer Störfelder. Die ebene Platte 13 befindet sich auf der dem Stromsensor 12 gegenüberliegenden Seite des Stromleiters 11. Die u-förmige Platte 13 umschliesst die Seiten und die dem Stromsensor 12 gegenüberliegenden Seite des Stromleiters 11. Stromleiter 11, Stromsensor 12 und Platte 13 sind bevorzugt als integrierter IC ausgeführt.

Die Fig. 8 bis 11 zeigen die Blockschemata verschiedener Möglichkeiten für die Verarbeitung der Hallspannungen der verschiedenen Hallelemente mit einem gemeinsamen Verstärker, sofern mindestens ein vertikales Hallelement VH und mindestens ein weiteres Hallelement vorhanden sind. Das mindestens eine weitere Hallelement HH kann, wie oben dargelegt, entweder ein horizontales oder ein vertikales Hallelement sein. Der Einfachheit halber wird in den Figuren für dieses Hallelement die Bezeichnung HH/VH verwendet und im Text als weiteres Hallelement bezeichnet.

Die Fig. 8 zeigt ein Ausführungsbeispiel, bei dem das vertikale Hallelement VH und das weitere Hallelement HH/VH strommässig parallel betrieben und deren Hallspannungssignale am Beginn der Verstärkerkette addiert und in einem gemeinsamen Verstärker 14 verstärkt werden. Damit ergibt sich am Ausgang eine Spannung U_{A}, die mit zunehmendem Magnetfeld monoton und stetig zunimmt, wie die in der Fig. 2 dargestellte Kennlinie.

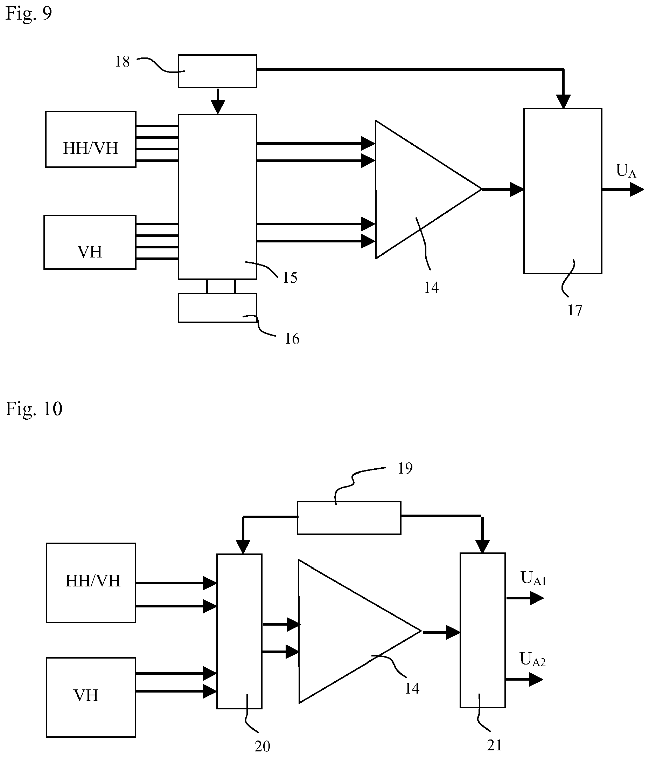

Die Fig. 9 zeigt ein Ausführungsbeispiel, bei dem das vertikale Hallelement VH und das weitere Hallelement HH/VH parallel und mit der spinning current Methode betrieben werden, bei der die Strom- und Spannungskontakte mit einer vorbestimmten Frequenz vertauscht werden, um Offsetfehler zu minimieren. Die Schaltung enthält einen Modulator 15, der die elektrischen Kontakte der Hallelemente alternierend mit einer Stromquelle 16 und dem Verstärker 14 verbindet, und einen Demodulator 17. Wie beim vorangehenden Beispiel werden die am Ausgang des Modulators 15 anliegenden Hallspannungen am Beginn der Verstärkerkette verstärkt. Der Modulator 15 und der Demodulator 17 werden von einem Zeitelement 18 gesteuert. Die Hallspannungen der Hallelemente HH und HH/VH werden also moduliert, im Verstärker addiert und verstärkt und dann demoduliert. Dadurch werden Halloffset und Verstärkeroffset reduziert. Am Ausgang erhält man wieder eine mit ansteigendem Magnetfeld monoton ansteigende, stetige Ausgangsspannung U_{A}.

Die Fig. 10 zeigt ein Ausführungsbeispiel, bei der die Hallelemente HH und HH/VH im Zeitmultiplexbetrieb, d.h. abwechslungsweise betrieben werden. Mittels eines von einem Steuerglied 19 gesteuerten Schalters 20 wird entweder die Hallspannung des vertikalen Hallelements VH oder die Hallspannung des weiteren Hallelements HH/VH dem Verstärker 14 zugeführt. In der Regel ist des sinnvoll, ein beispielsweise mit Sample&Hold Bausteinen versehenes Ausgangsglied 21 vorzusehen, dem die Information, welches Hallsignal verstärkt wird, vom Steuerglied 19 ebenfalls zugeführt wird, so dass das die verstärkte Hallspannung des Hallelements HH/VH repräsentierende Ausgangssignal U_{A1} und auch das die verstärkte Hallspannung des vertikalen Hallelements VH repräsentierende Ausgangssignal U_{A2} permanent zur Verfügung stehen. Wenn das weitere Hallelement ein horizontales Hallelement HH ist, dann weist das Ausgangssignal U_{A1} eine steile Kennlinie auf entsprechend der grossen Empfindlichkeit des horizontalen Hallelements HH. Die Kennlinie des Ausgangssignals U_{A2} hängt ab von der Positionierung des vertikalen Hallelements VH in Bezug auf die Magnetfeldkonzentratoren:
- Bei den Beispielen gemäss den Fig. 3 bis 5: Die Kennlinie ist am Anfang steil und wird dann flacher bei magnetischer Sättigung der Magnetfeldkonzentratoren, so wie bei der Fig. 2 dargestellt.
- Bei den Beispielen gemäss den Fig. 6 und 7: Die Kennlinie ist zunächst praktisch null, nimmt erst bei beginnender Sättigung des Magnetfeldkonzentrators zu und nimmt linear zu, sobald der Magnetfeldkonzentrator annähernd vollständig gesättigt ist.
- Wenn das vertikale Hallelement ausserhalb des Einflussbereichs des Magnetfeldkonzentrators platziert ist, dann steigt die Kennlinie linear mit dem externen Magnetfeld an.

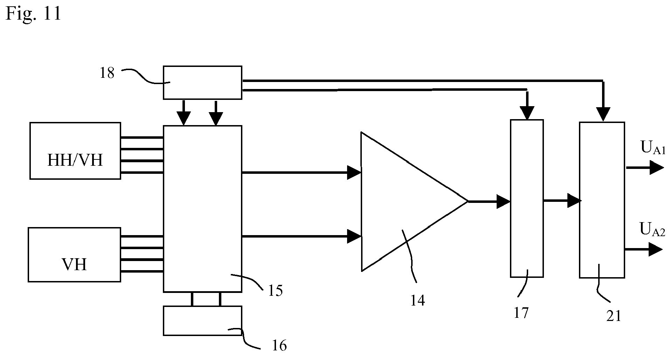

Die Fig. 11 zeigt ein Ausführungsbeispiel, das die Vorteile des Zeitmultiplexbetriebs und der spinning current Methode kombiniert. Die Phasen für den Betrieb des Hallelements HH/VH und des vertikalen Hallelements VH können verschieden lang sein.

## Patentansprüche

1. Stromsensor, mit zwei durch einen Luftspalt (4) getrennten Magnetfeldkonzentratoren (2; 3) und einem Hallelement, wobei die beiden Magnetfeldkonzentratoren (2; 3) auf einer Oberseite eines Halbleiterchips (1) angeordnet sind, das Hallelement ein vertikales Hallelement (8) ist, das im Bereich und unterhalb des Luftspalts (4) im Halbleiterchip (1) integriert ist, und eine elektronische Schaltung für den Betrieb des Hallelements und die Auswertung des vom Hallelement gelieferten Spannungssignals im Halbleiterchip (1) integriert ist.

2. Stromsensor nach Anspruch 1, **dadurch gekennzeichnet, dass** im Halbleiterchip (1) beidseits des Luftspalts (4) und unterhalb des jeweils darüberliegenden Magnetfeldkonzentrators (2 bzw. 3) je ein horizontales Hallelement (5; 6) integriert ist, so dass die horizontalen Hallelemente (5; 6) von Feldlinien (7) des Magnetfelds durchflutet werden, die vom einen Magnetfeldkonzentrator (2) in der Nähe des Luftspalts (4) weggehen und auf den anderen Magnetfeldkonzentrator (3) in der Nähe des Luftspalts (4) auftreffen, und dass die Hallspannungen aller Hallelemente (5; 6; 8) einem gemeinsamen Verstärker (14) zugeführt werden.

3. Stromsensor nach Anspruch 1 oder 2, **dadurch gekennzeichnet, dass** der Stromsensor auf einem Stromleiter (11) montiert ist oder dass der Stromleiter (11) in den Stromsensor integriert ist.

4. Vorrichtung mit einem Stromleiter (11) und einem auf dem Stromleiter (11) montierten Stromsensor nach Anspruch 1 oder 2, **dadurch gekennzeichnet, dass** für die Erhöhung der Empfindlichkeit des Stromsensors durch Bündelung des von dem durch den Stromleiter fliessenden Strom erzeugten Magnetfelds und die Abschirmung äusserer magnetischer Störfelder eine ebene Platte (13) aus ferromagnetischem Material vorhanden ist, die auf der dem Stromsensor gegenüberliegenden Seite des Stromleiters (11) angeordnet ist.

5. Vorrichtung mit einem Stromleiter (11) und einem auf dem Stromleiter (11) montierten Stromsensor nach Anspruch 1 oder 2, **dadurch gekennzeichnet, dass** für die Erhöhung der Empfindlichkeit des Stromsensors durch Bündelung des von dem durch den Stromleiter fliessenden Strom erzeugten Magnetfelds und die Abschirmung äusserer magnetischer Störfelder eine u-förmig gebogene Platte (13) aus ferromagnetischem Material vorhanden ist, die die beiden Seiten und die dem Stromsensor (12) gegenüberliegenden Seite des Stromleiters (11) umschliesst.

## Claims

1. Current sensor with two magnetic field concentrators (2; 3) separated by an air gap (4) and a Hall element, wherein the two magnetic field concentrators (2; 3) are arranged on an upper side of a semiconductor chip (1), the Hall element is a vertical Hall element (8) which is integrated in the semiconductor chip (1) in the region of and below the air gap (4), and an electronic circuit for the operation of the Hall element and the evaluation of the voltage signal supplied by the Hall element is integrated in the semiconductor chip (1).

2. Current sensor according to claim 1, **characterized in that**, in the semiconductor chip (1) on both sides of the air gap (4) and below the respective above lying magnetic field concentrator (2 or 3), a horizontal Hall element (5; 6) is integrated, so that the horizontal Hall elements (5; 6) are flooded by field lines (7) of the magnetic field, which leave one magnetic field concentrator (2) in the vicinity of the air gap (4) and impinge on the other magnetic field concentrator (3) in the vicinity of the air gap (4), and **in that** the Hall voltages of all the Hall elements (5; 6; 8) are fed to a common amplifier (14).

3. Current sensor according to claim 1 or 2, **characterized in that** the current sensor is mounted on a current conductor (11) or **in that** the current conductor (11) is integrated into the current sensor.

4. Device with a current conductor (11) and a current sensor according to claim 1 or 2 mounted on the current conductor (11), **characterized in that** for increasing the sensitivity of the current sensor by bundling the magnetic field generated by the current flowing through the current conductor and shielding external magnetic disturbance fields, a flat plate (13) of ferromagnetic material is provided which is arranged on the side of the current conductor (11) opposite the current sensor.

5. Device with a current conductor (11) and a current sensor according to claim 1 or 2 mounted on the current conductor (11), **characterized in that** for increasing the sensitivity of the current sensor by bundling the magnetic field generated by the current flowing through the current conductor and shielding external magnetic disturbance fields, a U-shaped curved plate (13) of ferromagnetic material is provided, which surrounds the two sides and the side of the current conductor (11) opposite the current sensor (12).

## Revendications

1. Capteur de courant comportant deux concentrateurs de champ magnétique (2 ; 3) séparés par un entrefer (4) et un élément à effet Hall, dans lequel les deux concentrateurs de champ magnétique (2 ; 3) sont disposés sur une face supérieure d'une puce à semi-conducteur (1), l'élément à effet Hall est un élément à effet Hall vertical (8) qui est intégré dans la puce à semi-conducteur (1) au voisinage et au-dessous de l'entrefer (4), et un circuit électronique pour faire fonctionner l'élément à effet Hall et évaluer le signal de tension fourni par l'élément à effet Hall est intégré dans la puce à semi-conducteur (1).

2. Capteur de courant selon la revendication 1, **caractérisé en ce qu'**un élément à effet Hall horizontal (5 ; 6) est intégré dans la puce à semi-conducteur (1) des deux côtés de l'entrefer (4) et sous le concentrateur de champ magnétique (2 ou 3) respective au-dessus de lui, de sorte que les éléments à effet Hall horizontaux (5 ; 6) sont traversés par des lignes de champ (7) du champ magnétique qui s'éloignent d'un concentrateur de champ magnétique (2) à proximité de l'entrefer (4) et empiètent sur l'autre concentrateur de champ magnétique (3) à proximité de l'entrefer (4) et que les tensions Hall de tous les éléments à effet Hall (5 ; 6 ; 8) sont transmises à un amplificateur commun (14).

3. Capteur de courant selon la revendication 1 ou 2, **caractérisé en ce que** le capteur de courant est monté sur un conducteur de courant (11) ou **en ce que** le conducteur de courant (11) est intégré dans le capteur de courant.

4. Dispositif comprenant un conducteur de courant (11) et un capteur de courant selon la revendication 1 ou 2 monté sur le conducteur de courant (11), **caractérisé en ce qu'**une plaque (13) plate en matériau ferromagnétique est prévue pour augmenter la sensibilité du capteur de courant en concentrant le champ magnétique généré par le courant traversant le conducteur de courant et en blindant les champs parasites magnétiques externes, qui est disposée du côté du conducteur de courant (11) opposé au capteur de courant.

5. Dispositif comprenant un conducteur de courant (11) et un capteur de courant selon la revendication 1 ou 2 monté sur le conducteur de courant (11), **caractérisé en ce qu'**une plaque (13) courbée en forme de U en matériau ferromagnétique est prévue pour augmenter la sensibilité du capteur de courant en concentrant le champ magnétique généré par le courant traversant le conducteur de courant et en blindant les champs parasites magnétiques externes, qui entoure les deux côtés et le côté du conducteur de courant (11) opposé au capteur de courant (12).
